# FASCICULE DE BREVET EUROPEEN

(11) **EP 3 478 043 B1**
(45) Date de publication et mention de la délivrance du brevet: **17.02.2021**
(21) Numéro de dépôt: 18202518.9
(22) Date de dépôt: 25.10.2018
(51) Int. Cl.: H05K 7/14

(54) **SYSTÈME ÉLECTRONIQUE AVEC AU MOINS UN DISPOSITIF DE SUPPORT DE CARTES**
ELEKTRONISCHES SYSTEM MIT MINDESTENS EINER HALTEVORRICHTUNG FÜR KARTEN
ELECTRONIC SYSTEM WITH AT LEAST ONE CARD SUPPORT DEVICE

(30) Priorité: 26.10.2017 FR 1760098
(43) Date de publication de la demande: 01.05.2019
(73) Titulaire: ALSTOM Transport Technologies, 93400 Saint-Ouen (FR)
(72) Inventeur: ZANETTI, Adrien, 69100 VILLEURBANNE (FR); BLANCHET, Damien, 01150 BLYES (FR)
(74) Mandataire: Lavoix

(56) Documents cités:
- EP-A1- 1 185 154
- WO-A1-03/009662
- US-A- 3 733 523

## Description

L'invention concerne un système électronique comprenant un châssis et au moins un dispositif de support configuré pour maintenir des cartes électroniques, chaque dispositif de support étant amovible par rapport au châssis, au moins deux cartes électroniques étant aptes à être maintenues verticalement l'une au-dessus de l'autre.

L'invention concerne alors le domaine des systèmes électroniques avec un châssis et des cartes électroniques destinées à être insérées dans le châssis, le châssis étant de préférence au format 6U et au moins certaines cartes électroniques étant de préférence au format 3U.

L'invention concerne notamment le domaine des systèmes électroniques embarqués, en particulier des systèmes électroniques embarqués à bord d'un véhicule, tel qu'un véhicule ferroviaire.

1U est une unité de longueur bien connue et définie selon la norme Eurocard, ou IEC-60297-3, ou encore selon les normes IEEE 1101.1, IEEE 1101.10 et IEEE 1101.11. 1U correspond à une longueur égale à 44,45 mm, c'est-à-dire égale à 1,75 pouces (de l'anglais *inch*).

Le format 3U correspond alors à une hauteur de châssis égale à 133,35 mm, soit 5,25 pouces, les cartes électroniques destinées au format 3U ayant alors une hauteur sensiblement égale à 100 mm. Le format 6U correspond à une hauteur de châssis égal à 266,70 mm, soit 10,5 pouces, les cartes électroniques destinées au format 6U ayant alors une hauteur sensiblement égale à 233,35 mm.

On connaît du document US 6,580,616 B2 un système électronique du type précité. Ce système électronique comprenant un châssis au format 6U et un dispositif de support configuré pour maintenir deux cartes électroniques au format 3U dans un même plan vertical. Les deux cartes électroniques au format 3U sont alors maintenues verticalement l'une au-dessus de l'autre. Le dispositif de support est amovible par rapport au châssis, et joue alors un rôle d'adaptateur mécanique entre les cartes électroniques au format 3U et le châssis au format 6U.

EP 1 185 154 A1, WO 03/009662 A1 et US 3,733,523 A décrivent aussi un système électronique du type précité.

Toutefois, un tel système électronique n'est pas très pratique et nécessite une manutention importante pour l'insertion dans le châssis, respectivement l'extraction du châssis, de ces cartes électroniques et dispositif(s) de support.

Le but de l'invention est donc de proposer un système électronique plus pratique et nécessitant moins de manutention pour l'insertion dans le châssis, respectivement l'extraction du châssis, des cartes électroniques et dispositif(s) de support.

À cet effet, l'invention a pour objet un système électronique selon la revendication 1.

Avec le système électronique selon l'invention, il est nécessaire de prévoir un nombre bien moins important de dispositif(s) de support pour réaliser l'adaptation mécanique entre les cartes électroniques à un premier format, tel que le format 3U, et le châssis à un deuxième format, tel que le format 6U, chaque dispositif de support étant configuré pour maintenir plusieurs cartes électroniques dans des plans distincts, décalés latéralement l'un par rapport à l'autre.

L'insertion des cartes électroniques dans le châssis, respectivement l'extraction des cartes du châssis, est alors grandement facilitée

Suivant d'autres aspects avantageux de l'invention, le système électronique est selon l'une quelconque des revendications 2 à 7.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une vue en perspective d'un système électronique comprenant un châssis et un dispositif de support configuré pour maintenir des cartes électroniques, selon un premier mode de réalisation de l'invention ;
- la figure 2 est une vue analogue à celle de la figure 1, selon un deuxième mode de réalisation de l'invention ;
- la figure 3 est une vue analogue à celle de la figure 1, selon un troisième mode de réalisation de l'invention ; et
- la figure 4 est une vue en perspective du dispositif de support de la figure 3.

Dans la suite de la description, les termes « avant », « arrière », « droite », « gauche », « haut », « bas », « longitudinal », « transversal » et « vertical » s'entendent par référence au système d'axe orthogonal usuel, représenté sur certaines figures et possédant :
- un axe longitudinal X dirigé de l'arrière vers l'avant ;
- un axe transversal Y dirigé de la droite vers la gauche ; et
- un axe vertical Z, dirigé du bas vers le haut.

Dans la suite de la description, l'expression « sensiblement égal à » définit une relation d'égalité à plus ou moins 10%, de préférence à plus ou moins 5%.

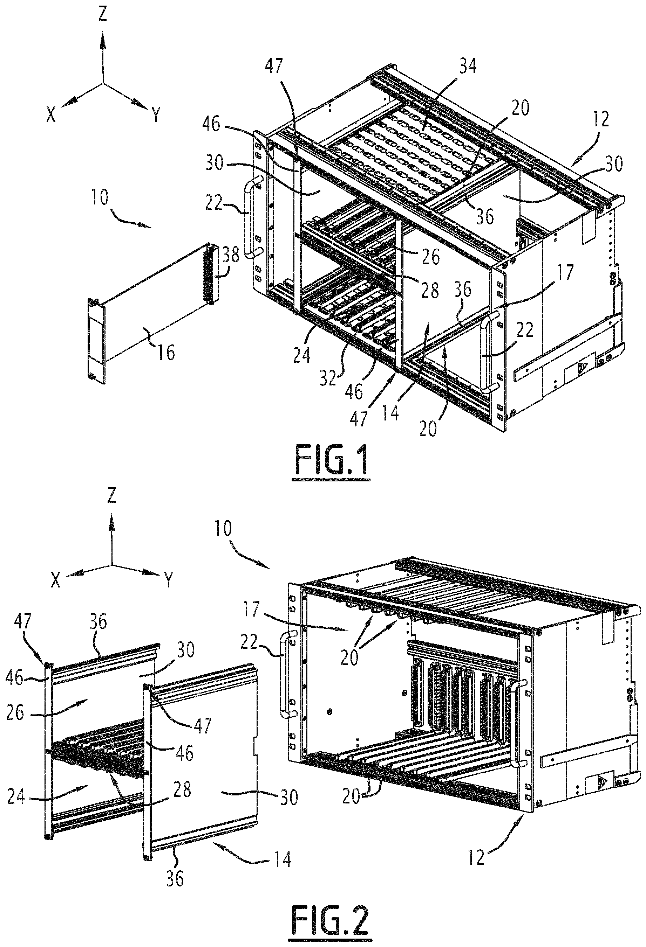

Sur la figure 1, un système électronique 10 comprend un châssis 12 et au moins un dispositif de support 14 configuré pour maintenir des cartes électroniques 16, le ou chaque dispositif de support 14 étant amovible par rapport au châssis12.

Le système électronique 10 est, par exemple, un système avec un châssis 12 au format 6U au sens de la norme Eurocard, ou IEC-60297-3, ou encore selon les normes IEEE 1101.1, IEEE 1101.10 et IEEE 1101.11. Les cartes électroniques 16 sont alors, par exemple, des cartes au format 3U ou au format 6U. Les cartes au format 6U sont directement insérables ou extractibles du châssis 12. Les cartes au format 3U sont connectables au châssis 12 via le dispositif de support 14, le dispositif de support 14 jouant alors un rôle d'adaptateur mécanique entre les cartes électroniques 16 au format 3U et le châssis 12 au format 6U.

Dans l'exemple de la figure 1, le système électronique 10 comprend un seul dispositif de support 14. Seule une carte électronique 16 est représentée sur la figure 1 par souci de simplification du dessin.

Le système électronique 10 est de préférence un système électronique embarqué, notamment un système embarqué à bord d'un véhicule, tel qu'un véhicule ferroviaire.

Le châssis 12 comporte à l'avant une ouverture 17 pour recevoir le ou les dispositifs de support 14, ainsi que les cartes électroniques 16 qui sont directement au format du châssis 12, et à l'arrière une carte de fond de plancher 18 (de l'anglais *backplane*), également appelée carte de fond de panier, pour connecter électriquement le ou les dispositifs de support 14 et/ou les cartes électroniques 16, notamment celles qui sont directement au format du châssis 12. L'ouverture 17 est de préférence rectangulaire.

Le châssis 12 comporte des premières rainures 20 pour guider chaque dispositif de support 14, ainsi que les cartes électroniques 16 au format du châssis, depuis l'ouverture 17 jusqu'à la carte de fond de plancher 18.

Le châssis 12 est de préférence réalisé en un matériau thermiquement conducteur, pour faciliter l'évacuation vers l'extérieur de la chaleur dissipée par le ou les dispositifs de support 14 et par les cartes électroniques 16. Le châssis 12 est par exemple réalisé en aluminium.

Le châssis 12 est par exemple en forme d'un parallélépipède rectangle, avec une hauteur H selon l'axe vertical Z, une longueur L selon l'axe longitudinal X et une largeur W selon l'axe transversal Y.

La hauteur H est de préférence compatible avec le format 6U. La longueur L correspond à la profondeur du châssis 12, et est légèrement supérieure à la longueur de chaque dispositif de support 14 selon l'axe longitudinal X. La largeur W est variable, et dépend du nombre de cartes électroniques 16 destinées à être insérées dans le châssis 12, soit directement, soit via un dispositif de support 14 respectif.

La hauteur H est, par exemple, sensiblement égale à 266,70 mm dans le cas d'un format 6U. La longueur L est par exemple sensiblement égale à 24 cm, et la largeur W est de préférence comprise entre 15 cm et 45 cm.

Dans l'exemple de la figure 1, le châssis 12 comporte en outre une paire de poignées de préhension 22, pour faciliter sa manutention.

Chaque dispositif de support 14 est configuré pour maintenir plusieurs cartes électroniques 16, avec au moins deux cartes électroniques 16 aptes à être maintenues verticalement l'une au-dessus de l'autre, et en outre plusieurs cartes électroniques 16 aptes à être maintenues dans des plans distincts, décalés latéralement l'un par rapport à l'autre. Dans les exemples des figures 1 à 4, plusieurs cartes électroniques 16 sont aptes à être maintenues dans des plans transversaux distincts, c'est-à-dire dans des plans décalés l'un par rapport à l'autre suivant l'axe transversal Y.

Chaque dispositif de support 14 est par exemple configuré, d'une part, pour maintenir au moins deux cartes électroniques 16 sensiblement dans un même plan, tel qu'un plan vertical contenant l'axe longitudinal X et l'axe vertical Z dans les exemples des figures 1 à 4, et d'autre part, pour maintenir au moins deux cartes électroniques dans des plans distincts sensiblement parallèles, tels que dans les exemples des figures 1 à 4 des plans verticaux parallèles et distincts, contenant chacun l'axe longitudinal X et l'axe vertical Z.

Chaque dispositif de support 14 est configuré pour maintenir au moins quatre cartes électroniques 16. Dans les exemples des figures 1 à 4, chaque dispositif de support 14 est configuré pour maintenir douze cartes électroniques 16.

Chaque dispositif de support 14 comporte des logements de réception 24, 26 pour recevoir des cartes électroniques 16, un premier logement de réception 24 pour recevoir des cartes électroniques 16 inférieures, un deuxième logement de réception 26 pour recevoir des cartes électroniques 16 supérieures, et une âme 28 disposée entre les premier et deuxième logements 24, 26. Les logements de réception 24, 26 sont délimités par deux parois latérales 30, tel que des parois latérales verticales dans les exemples des figures 1 à 4, contenant chacune l'axe longitudinal X et l'axe vertical Z.

Dans les exemples des figures 1, 3 et 4, chaque dispositif de support 14 comporte, en complément des deux parois latérales 30, une paroi inférieure 32 et une paroi supérieure 34. Dans ces exemples, le premier logement de réception 24 est délimité par les deux parois latérales 30 d'une part, et par la paroi inférieure 32 et l'âme 28 d'autre part, le deuxième logement de réception 26 étant délimité par les deux parois latérales 30 d'une part, et par l'âme 28 et la paroi supérieure 34 d'autre part. Autrement dit, dans ces exemples des figures 1, 3 et 4, chaque dispositif de support 14 présente, en coupe suivant un plan vertical contenant l'axe transversal Y et l'axe vertical Z, une section en forme de 8, ou encore en forme de θ.

Chaque dispositif de support 14 est configuré pour être en appui mécanique contre le châssis 12, en l'absence d'un contact entre le châssis 12 et l'une quelconque des cartes électroniques 16 maintenues par le dispositif de support 14 respectif.

Chaque dispositif de support 14 est configuré pour être inséré par coulissement dans le châssis 12, et comprend au moins une rainure 36, également appelée deuxième rainure 36, apte à coopérer avec une rainure complémentaire 20 du châssis 12, également appelée première rainure 20.

Chaque dispositif de support 14 est de préférence fixé par l'avant sur le châssis 12, par l'intermédiaire de montants 46 et d'éléments de visserie 47.

Ainsi, le dispositif de support 14 s'insère et se fixe sensiblement de la même manière qu'une carte au format du châssis 12, bénéficiant ainsi des mêmes avantages en termes de manutention.

Chaque dispositif de support 14 est de préférence configuré pour maintenir des cartes électroniques 16 au format 3U, et forme alors un adaptateur mécanique entre les cartes électroniques 16 au format 3U et le châssis 12 au format 6U.

Les cartes électroniques 16 de chaque dispositif de support 14 selon l'invention sont montées dans le châssis 12 par l'intermédiaire d'un dispositif de support 14 respectif, et sont portées par ledit dispositif de support 14. L'homme du métier observera que le dispositif de support 14 est bien entendu également apte à supporter une seule carte électronique 16 lorsqu'une seule carte électronique 16 est présente.

Chaque carte électronique 16 est connue en soi, et est de préférence d'un type choisi parmi le type 3U et le type 6U au sens de la norme Eurocard, ou IEC-60297-3, ou encore selon les normes IEEE 1101.1, IEEE 1101.10 et IEEE 1101.11.

Chaque carte électronique 16 comporte un circuit imprimé et des composants, non représentés, connectés électriquement au circuit imprimé.

Dans les exemples des figures 1 à 4, chaque carte électronique 16 s'étend sensiblement dans un plan vertical comportant l'axe longitudinal X et l'axe vertical Z.

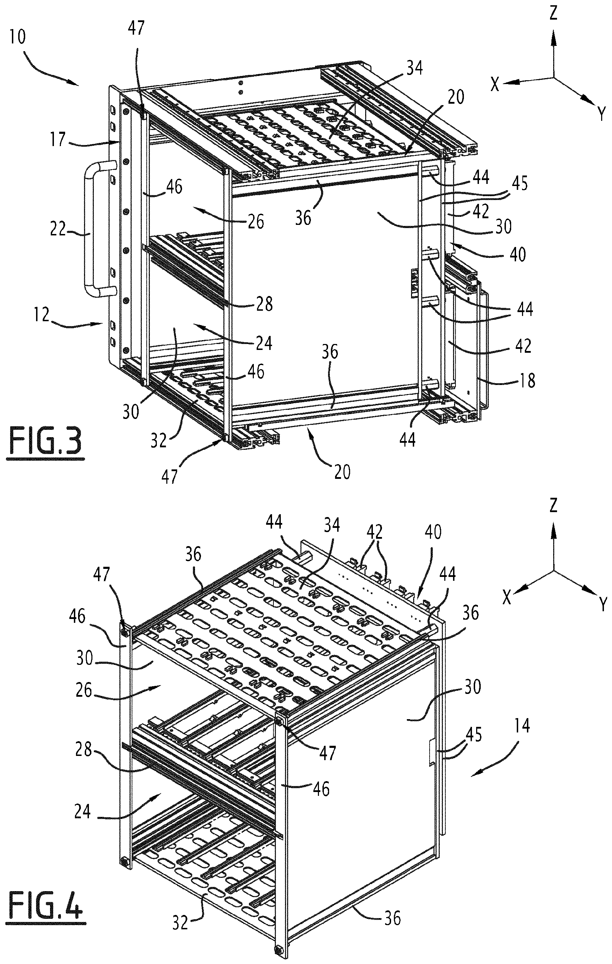

Chaque carte électronique 16 comporte en outre un connecteur arrière 38, visible sur la figure 1, pour sa connexion électrique avec la carte de fond de plancher 18 ou bien avec une platine de connexion 40 dans la variante de réalisation des figures 3 et 4.

Chaque carte électronique 16 présente soit une longueur sensiblement égale à 220 mm selon l'axe longitudinal X lorsqu'elle est prévue pour être connectée directement à la carte de fond de plancher 18, soit une longueur sensiblement égale à 160 mm selon l'axe longitudinal X lorsqu'elle est prévue pour être connectée à la platine de connexion 40 dans la variante de réalisation des figures 3 et 4.

L'âme 28 et les parois latérales 30, ainsi qu'en complément facultatif les parois inférieure 32 et supérieure 34, sont réalisées de préférence en un matériau thermiquement conducteur, pour véhiculer par conduction l'énergie thermique dissipée par les cartes électroniques 16. L'âme 28 et les parois latérales 30, ainsi qu'en complément facultatif les parois inférieure 32 et supérieure 34, sont par exemple réalisées en aluminium, acier inoxydable, cuivre, laiton nickelé.

Dans les exemples des figures 1 à 4, l'âme 28 est configurée pour former un séparateur entre le premier logement de réception 24 recevant les cartes électroniques 16 inférieures et le deuxième logement de réception 26 recevant les cartes électroniques 16 supérieures.

Dans les exemples des figures 1 à 4, l'âme 28 est en forme de poutres horizontales s'étendant suivant l'axe transversal Y solidaires de guides-cartes s'étendant suivant l'axe longitudinal X. En variante, l'âme 28 est en forme d'une paroi horizontale contenant l'axe longitudinal X et l'axe transversal Y.

Ainsi, le système électronique 10 selon l'invention permet de réaliser l'adaptation mécanique entre les cartes électroniques 16 à un premier format, tel que le format 3U, et le châssis 12 à un deuxième format, tel que le format 6U, avec un faible nombre de dispositif(s) de support 14, voire avec un seul dispositif de support 14 comme dans les exemples des figures 1 à 4. Chaque dispositif de support 14 est en effet configuré pour maintenir à la fois plusieurs cartes électroniques 16 verticalement l'une au-dessus de l'autre et plusieurs cartes électroniques 16 dans des plans distincts, décalés latéralement l'un par rapport à l'autre.

Chaque dispositif de support 14 est alors configuré pour maintenir au moins quatre cartes électroniques 16, voire bien davantage, comme dans les exemples des figures 1 à 4, où chaque dispositif de support 14 est configuré pour maintenir douze cartes électroniques 16.

En outre, chaque dispositif de support 14 permet d'extraire une ou plusieurs cartes électroniques 16 du dispositif de support, sans qu'il soit nécessaire d'extraire ledit dispositif de support 14 du châssis 12.

Le système électronique 10 selon l'invention permet au final d'insérer/extraire très facilement aussi bien des cartes électroniques 16 au premier format, tel que le format 3U, que des cartes électroniques 16 au deuxième format, tel que le format 6U, dans/depuis le châssis 12 au deuxième format, tel que le format 6U.

La figure 2 illustre un deuxième mode de réalisation de l'invention pour lesquels les éléments analogues au premier mode de réalisation, décrit précédemment, sont repérés par des références identiques, et ne sont donc pas décrits à nouveau.

Selon le deuxième mode de réalisation, chaque dispositif de support 14 comporte les deux parois latérales 30 en complément de l'âme 28, et ne comporte pas de paroi inférieure, ni de paroi supérieure.

Selon ce deuxième mode de réalisation, le premier logement de réception 24 est alors délimité par les deux parois latérales 30 d'une part, et par l'âme 28 et une paroi inférieure du châssis 12 d'autre part, le deuxième logement de réception 26 étant délimité par les deux parois latérales 30 d'une part, et par l'âme 28 et une paroi supérieure du châssis 12 d'autre part.

Autrement dit, selon ce deuxième mode de réalisation, chaque dispositif de support 14 présente, en coupe suivant un plan vertical contenant l'axe transversal Y et l'axe vertical Z, une section en forme de H.

Le fonctionnement de ce deuxième mode de réalisation est identique à celui du premier mode de réalisation et n'est donc pas décrit à nouveau.

Les avantages de ce deuxième mode de réalisation sont identiques à ceux du premier mode de réalisation et ne sont donc pas décrits à nouveau. En particulier, le dispositif de support 14 selon ce deuxième mode de réalisation est plus léger et moins coûteux de par l'absence de parois inférieure et supérieure.

Les figures 3 et 4 illustrent un troisième mode de réalisation de l'invention pour lequel les éléments analogues au premier mode de réalisation, décrit précédemment, sont repérés par des références identiques, et ne sont donc pas décrits à nouveau.

Selon le troisième mode de réalisation, au moins un dispositif de support 14 comporte en outre la platine de connexion 40, la platine de connexion 40 comportant un ensemble de carte électroniques 45 et de connecteurs électriques 42 pour la connexion électrique au châssis 12 des cartes électroniques 16 maintenues par ledit dispositif de support 14. Ledit dispositif de support 14 comporte en outre des entretoises 44 configurées pour relier mécaniquement la platine de connexion 40 aux parois latérales 30 ou bien configurées pour relier mécaniquement deux cartes électroniques de l'ensemble de cartes 45, l'une de ces cartes étant alors fixée aux parois latérales. La platine de connexion 40 est par exemple constituée dudit ensemble de carte électroniques 45, des entretoises 44 et des connecteurs électriques 42.

Les entretoises 44 présentent alors par exemple, selon l'axe longitudinal X, une longueur permettant de réaliser une adaptation de longueur entre des cartes électroniques 16 de longueur 160 mm et le châssis 12 destiné à recevoir par défaut des cartes électroniques de longueur 220 mm. La longueur des entretoises 44 est donc inférieure à 60 mm, et typiquement comprise entre 10 mm et 50 mm, de préférence encore comprise entre 20 mm et 40 mm, suivant la taille des connecteurs 42.

Le fonctionnement de ce troisième mode de réalisation est identique à celui du premier mode de réalisation et n'est donc pas décrit à nouveau.

Les avantages de ce troisième mode de réalisation sont identiques à ceux du premier mode de réalisation et ne sont donc pas décrits à nouveau. En outre, le système électronique 10 selon ce troisième mode de réalisation permet une adaptation avec des cartes électroniques 16 de longueur 160 mm, aussi bien qu'avec des cartes électroniques de longueur 220 mm de par la platine de connexion 40 et les entretoises 44 associées.

On conçoit ainsi que le système électronique 10 selon l'invention est plus pratique et nécessite une moindre manutention pour l'insertion dans le châssis 12, respectivement l'extraction du châssis 12, des cartes électroniques 16 et dispositif(s) de support 14.

## Revendications

1. Système électronique (10) comprenant :
- un châssis (12),
- au moins un dispositif de support (14) configuré pour maintenir des cartes électroniques (16), chaque dispositif de support (14) étant amovible par rapport au châssis (12), au moins deux cartes électroniques (16) étant aptes à être maintenues verticalement l'une au-dessus de l'autre,
**caractérisé en ce que** chaque dispositif de support (14) est configuré en outre pour maintenir plusieurs cartes électroniques (16) dans des plans distincts, décalés latéralement l'un par rapport à l'autre, chaque dispositif de support (14) comportant un premier logement de réception (24) pour recevoir des cartes électroniques (16) inférieures, un deuxième logement de réception (26) pour recevoir des cartes électroniques (16) supérieures, et une âme (28) disposée entre les premier (24) et deuxième (26) logements de réception ; les logements de réception (24, 26) étant délimités par deux parois latérales (30) ; l'âme (28) et les parois latérales (30) étant réalisées en un matériau thermiquement conducteur, pour véhiculer par conduction l'énergie thermique dissipée par les cartes électroniques (16), et
**en ce que** le châssis (12) est un châssis au format 6U et chaque dispositif de support (14) est configuré pour maintenir des cartes électroniques (16) au format 3U.

2. Système électronique (10) selon la revendication 1, dans lequel chaque dispositif de support (14) est configuré, d'une part, pour maintenir au moins deux cartes électroniques (16) sensiblement dans un même plan, et d'autre part, pour maintenir au moins deux cartes électroniques (16) dans des plans distincts sensiblement parallèles.

3. Système électronique (10) selon l'une quelconque des revendications précédentes, dans lequel au moins un dispositif de support (14) comporte en outre une platine de connexion (40), la platine de connexion (40) étant équipée de connecteurs électriques (42) pour la connexion électrique au châssis (12) des cartes électroniques (16) maintenues par ledit dispositif de support (14).

4. Système électronique (10) selon la revendication 3, dans lequel ledit dispositif de support (14) comporte en outre des entretoises (44) configurées pour relier mécaniquement la platine de connexion (40) aux parois latérales (30).

5. Système électronique (10) selon l'une quelconque des revendications précédentes, dans lequel chaque dispositif de support (14) est configuré pour maintenir au moins quatre cartes électroniques (16).

6. Système électronique (10) selon l'une quelconque des revendications précédentes, dans lequel chaque dispositif de support (14) est configuré pour être en appui mécanique contre le châssis (12), en l'absence d'un contact entre le châssis (12) et l'une quelconque des cartes électroniques (16) maintenues par le dispositif de support (14) respectif.

7. Système électronique (10) selon l'une quelconque des revendications précédentes, dans lequel chaque dispositif de support (14) est configuré pour être inséré par coulissement dans le châssis (12), et comprend au moins une rainure (36) apte à coopérer avec une rainure complémentaire (20) du châssis (12).

## Patentansprüche

1. Elektroniksystem (10), aufweisend:
- einen Rahmen (12),
- mindestens eine Abstützvorrichtung (14), welche dazu eingerichtet ist, Elektronikkarten (16) zu halten, wobei jede Abstützvorrichtung (14) bezüglich des Rahmens (12) herausnehmbar ist, wobei mindestens zwei Elektronikkarten (16) dazu geeignet sind, eine vertikal übereinander gehalten zu werden,
**gekennzeichnet dadurch, dass** jede Abstützvorrichtung (14) ferner dazu eingerichtet ist, mehrere Elektronikkarten (16) in unterschiedlichen Ebenen, welche zueinander seitlich versetzt sind, zu halten, wobei jede Abstützvorrichtung (14) eine erste Aufnahmekammer (24) zum Aufnehmen von unteren Elektronikkarten (16), eine zweite Aufnahmekammer (26) zum Aufnehmen von oberen Elektronikkarten (16) und einen Steg (28), welcher zwischen der ersten (24) und der zweiten (26) Aufnahmekammer angeordnet ist, aufweist, wobei die Aufnahmekammern (24, 26) durch zwei Seitenwände (30) begrenzt sind, wobei der Steg (28) und die Seitenwände (30) aus einem wärmeleitenden Material gefertigt sind, um die durch die Elektronikkarten (16) abgegebene Wärmeenergie mittels Konduktion zu übertragen, und
und dadurch, dass der Rahmen (12) ein Rahmen im Format 6U ist und jede Abstützvorrichtung (14) dazu eingerichtet ist, Elektronikkarten (16) im Format 3U zu halten.

2. Elektroniksystem (10) gemäß dem Anspruch 1, wobei jede Abstützvorrichtung (14) dazu eingerichtet ist, einerseits mindestens zwei Elektronikkarten (16) im Wesentlichen in einer gleichen Ebene zu halten und andererseits mindestens zwei Elektronikkarten (16) in unterschiedlichen Ebenen, welche im Wesentlichen parallel sind, zu halten.

3. Elektroniksystem (10) gemäß irgendeinem der vorhergehenden Ansprüche, wobei mindestens eine Abstützvorrichtung (14) ferner eine Verbindungsplatte (40) aufweist, wobei die Verbindungsplatte (40) mit elektrischen Verbindern (42) für die elektrische Verbindung der durch die Abstützvorrichtung (14) gehaltenen Elektronikkarten (16) mit dem Rahmen (12) ausgestattet ist.

4. Elektroniksystem (10) gemäß dem Anspruch 3, wobei die Abstützvorrichtung (14) ferner Abstandshalter (44) aufweist, welche dazu eingerichtet sind, die Verbindungsplatte (40) mit den Seitenwänden (30) mechanisch zu verbinden.

5. Elektroniksystem (10) gemäß irgendeinem der vorhergehenden Ansprüche, wobei jede Abstützvorrichtung (14) dazu eingerichtet ist, mindestens vier Elektronikkarten (16) zu halten.

6. Elektroniksystem (10) gemäß irgendeinem der vorhergehenden Ansprüche, wobei jede Abstützvorrichtung (14) dazu eingerichtet ist, gegen den Rahmen (12) in mechanischer Anlage zu sein, ohne Kontakt zwischen dem Rahmen (12) und irgendeiner der Elektronikkarten (16), welche durch die jeweilige Abstützvorrichtung (14) gehalten werden.

7. Elektroniksystem (10) gemäß irgendeinem der vorhergehenden Ansprüche, wobei jede Abstützvorrichtung (14) dazu eingerichtet ist, durch Schieben in den Rahmen (12) eingesetzt zu werden, und mindestens eine Nut (36), welche dazu geeignet ist, mit einer komplementären Nut (20) des Rahmens (12) zusammenzuwirken, aufweist.

## Claims

1. Electronic system (1) comprising:
- a chassis (12),
- at least one support device (14) configured to retain electronic cards (16), each support device (14) being detachable relative to the chassis (12), at least two electronic cards (16) being able to be retained vertically one above the other,
**characterised in that** each support device (14) is configured, furthermore, to retain several electronic cards (16) in separate planes, offset laterally one relative to the other, each support device (14) comprising a first reception housing (24) for receiving lower electronic cards (16), a second reception housing (26) for receiving upper electronic cards (16) and a core (28) which is disposed between the first (24) and second (26) reception housings; the reception housings (24, 26) being delimited by two lateral walls (30); the core (28) and the lateral walls (30) being produced in a thermally conductive material in order to convey by conduction the thermal energy dissipated by the electronic cards (16), and
**in that** the chassis (12) is a 6U format chassis and each support device (14) is configured to retain electronic cards (16) in the 3U format.

2. Electronic system (10) according to claim 1, in which each support device (14) is configured, on the one hand, to retain at least two electronic cards (16) substantially in the same plane and, on the other hand, to retain at least two electronic cards (16) in separate planes which are substantially parallel.

3. Electronic system (10) according to any of the preceding claims, in which at least one support device (14) comprises, furthermore, a connection plate (40), the connection plate (40) being fitted with electrical connectors (42) for the electrical connection to the chassis (12) of the electronic cards (16) retained by said support device (14).

4. Electronic system (10) according to claim 3, in which said support device (14) comprises, furthermore, crosspieces (44) configured to connect mechanically the connection plate (40) to the lateral walls (30).

5. Electronic system (10) according to any of the preceding claims, in which each support device (14) is configured to retain at least four electronic cards (16).

6. Electronic system (10) according to any of the preceding claims, in which each support device (14) is configured to be supported mechanically against the chassis (12), in the absence of a contact between the chassis (12) and any of the electronic cards (16) retained by the respective support device (14).

7. Electronic system (10) according to any of the preceding claims, in which each support device (14) is configured to be inserted by sliding into the chassis (12) and comprises at least one groove (36) which is able to cooperate with a complementary groove (20) of the chassis (12).
